# EUROPÄISCHE PATENTANMELDUNG

(11) **EP 0 718 883 A2**
(43) Veröffentlichungstag der Anmeldung: **26.06.1996**
(21) Anmeldenummer: 95119800.1
(22) Anmeldetag: 15.12.1995
(51) Int. Cl.: H01L 23/36

(54) **Vorrichtung zum Abführen von Wärme von einem elektronischen Bauelement**

(30) Priorität: 22.12.1994 DE 4445849
(71) Anmelder: Alcatel SEL Aktiengesellschaft, D-70435 Stuttgart (DE)
(72) Erfinder: Ferling, Dieter, D-70199 Stuttgart (DE); Heck, Wolfgang, D-70839 Gerlingen (DE); Adam, Klaus, D-73035 Göppingen (DE); Hirler, Hans-Peter, D-73235 Weilheim (DE)
(74) Vertreter: Knecht, Ulrich Karl

(57) **Zusammenfassung**

Die Erfindung betrifft eine lösbare Wärmebrücke zwischen einem Halbleiterchip und einem Kühlkörper.

Sowohl an dem Halbleiterchip als auch am Kühlkörper ist jeweils eine Bürste befestigt, welche aus einem Bürstenkörper und Metallborsten besteht.

In der Endstellung von Kühlkörper und Halbleiterchip dringen die Borsten der Bürsten ineinander und bilden die Wärmebrücke.

## Beschreibung

Die Erfindung betrifft eine Vorrichtung zum Abführen von Wärme von einem elektronischen Bauelement mit einer lösbar zwischen dem Bauelement und einem Kühlkörper angeordneten Bürste mit Borsten aus einem gut wärmeleitenden Werkstoff.

Eine solche Vorrichtung ist bekannt (IBM Technical Disclosure Bulletin, Vol. 21, No. 5, Oct. 1978, Seite 1857). Die bekannte Vorrichtung besteht aus einer Bürste, deren Bürstenkörper mittels einer Druckfeder vorgespannt in einer Vertiefung des Kühlkörpers geführt ist und deren Borstenenden mit der Oberfläche des zu kühlenden elektrischen Bauelementes in Kontakt stehen.

Die bekannte Vorrichtung weist den Nachteil auf, daß sie nur eine begrenzte Wärmeableitungskapazität aufweist. An der einen Übergangsstelle der Wärme vom elektrischen Bauelement zu den Borsten ist eine Vielzahl von punktförmigen wärmeleitenden Kontakten vorhanden und an der anderen Übergangsstelle muß die Wärme über eine Schraubenfeder abgeführt werden.

Das der Erfindung zugrunde liegende technische Problem besteht deshalb darin, die bekannte Vorrichtung in der Weise zu verbessern, daß einerseits eine hohe Wärmeleitfähigkeit zwischen dem elektrischen Bauelement und dem Kühlkörper vorhanden ist und sie andererseits auf einfache Weise einen Toleranzausgleich bei den mechanischen Abmessungen gestattet.

Dieses technische Problem ist erfindungsgemäß dadurch gelöst, daß sie aus zwei Bürsten besteht, welche derart einander gegenüberliegend angeordnet sind, daß die Rückseite des einen Bürstenkörpers mit dem Bauelement und die Rückseite des anderen Bürstenkörpers mit dem Kühlkörper in Kontakt steht und die Borsten beider Bürsten wenigstens teilweise ineinander greifen.

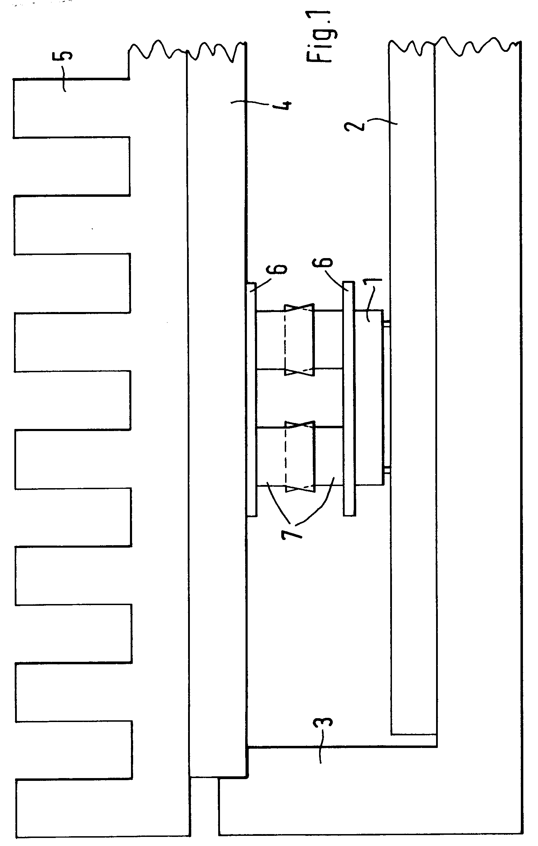

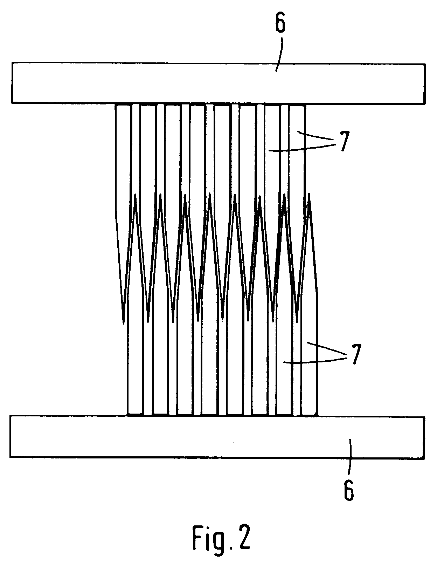

Die Erfindung ist nachstehend anhand der Figuren 1 und 2 erläutert.
Es zeigen:
- Fig. 1: in Seitenansicht ein Ausführungsbeispiel der erfindungsgemäßen Vorrichtung und
- Fig. 2: in vergrößerter Darstellung die teilweise ineinandergreifenden Bürsten.

Wie aus Fig. 1 zu erkennen ist, kann es sich bei dem zu kühlenden elektrischen Bauelement 1 um ein Halbleiterchip handeln, welches in Flip-Chip-Technik auf dem Substrat 2 angeordnet ist. Das Substrat 2, auf dem natürlich eine Vielzahl von Bauelementen mit einer Vielzahl von Vorrichtungen zur Wärmeabfuhr angeordnet sein können, ist in dem Gehäuse 3 angeordnet, welches mit dem Deckel 4 verschlossen ist. Der Deckel 4 ist außerdem mit dem Kühlkörper 5 versehen.

Die Wärmeleitung zwischen der Oberfläche des Bauelements 1 und dem Deckel 4 wird durch die beiden Bürsten hergestellt, von denen jede aus einem Bürstenkörper 6 und den mit diesen verbundenen Borsten 7 besteht. Die Borsten 7 sollten aus einem metallischen Werkstoff bestehen, der über eine ausreichende Steifigkeit und gute thermische Leitfähigkeit, wie Messingdraht, verfügt. Wie aus Fig. 1 zu erkennen ist, greifen die Borsten 7 auf einem Teil ihrer Länge ineinander.

Das ist noch besser aus Fig. 2 zu erkennen, welche die beiden Bürsten mit ineinandner greifenden Borsten 7 zeigt.

## Patentansprüche

1. Vorrichtung zum Abführen von Wärme von einem elektronischen Bauelement mit einer lösbar zwischen dem Bauelement und einem Kühlkörper angeordneten Bürste mit Borsten aus einem gut wärmeleitenden Werkstoff,
**dadurch gekennzeichnet,** daß sie aus zwei Bürsten besteht, welche derart einander gegenüberliegend angeordnet sind, daß die Rückseite des einen Bürstenkörpers (6) mit dem Bauelement (1) und die Rückseite des anderen Bürstenkörpers (6) mit dem Kühlkörper (5) in Kontakt steht und die Borsten (7) beider Bürsten wenigstens teilweise ineinander greifen.
